# EUROPÄISCHE PATENTSCHRIFT

(11) **EP 2 958 732 B1**
(45) Veröffentlichungstag und Bekanntmachung des Hinweises auf die Patenterteilung: **27.09.2017**
(21) Anmeldenummer: 14711679.2
(22) Anmeldetag: 17.02.2014
(51) Int. Cl.: B29C 49/42, B29C 49/46, B29C 49/14, B29C 49/16

(54) **VERFAHREN UND VORRICHTUNG ZUM HERSTELLEN UND FÜLLEN VON BEHÄLTERN**
METHOD AND DEVICE FOR PRODUCING AND FILLING CONTAINERS
PROCÉDÉ ET DISPOSITIF DE FABRICATION ET DE REMPLISSAGE DE CONTENANTS

(30) Priorität: 19.02.2013 DE 102013101642
(43) Veröffentlichungstag der Anmeldung: 30.12.2015
(73) Patentinhaber: KHS GmbH, 44143 Dortmund (DE)
(72) Erfinder: CLÜSSERATH, Ludwig, 55543 Bad Kreuznach (DE)
(86) Internationale Anmeldenummer: PCT/EP2014/000428
(87) Internationale Veröffentlichungsnummer: WO 2014/127903

(56) Entgegenhaltungen:
- WO-A1-2009/075791
- FR-A1- 2 774 912

## Beschreibung

Die vorliegende Erfindung betrifft ein Verfahren zur Herstellung von Behältern aus Vorformlingen sowie eine Vorrichtung hierfür.

Bekannt ist aus der DE 43 40 291 die Herstellung von Behältern durch Blasformen mit einem gas- und/oder dampfförmigen Druckmedium aus Vorformlingen aus einem thermoplastischen Material, beispielsweise aus Vorformlingen aus PET (Polyethylenterephthalat), wobei die Vorformlinge innerhalb einer Blasmaschine unterschiedlichen Bearbeitungsstationen zugeführt werden. Typischerweise weist eine Blasmaschine eine Heizeinrichtung zum Temperieren oder Vorerhitzen (thermisches Konditionieren) der Vorformlinge sowie eine Blaseinrichtung mit wenigstens einer Blasstation auf, in deren Bereich der jeweils zuvor temperierte Vorformling biaxial oder multiaxial zu einem Behälter expandiert wird. Die Expansion erfolgt mit Hilfe eines Druckgases, z.B. mit Hilfe von Druckluft, als Druckmedium, das mit einem Formdruck in den zu expandierenden Vorformling eingeleitet wird. Der verfahrenstechnische Ablauf bei einer derartigen Expansion des Vorformlings wird in der DE 43 40 291 erläutert.

Der grundsätzliche Aufbau der Blasstation ist in der DE 42 12 583 beschrieben. Möglichkeiten der Temperierung der Vorformlinge sind in der DE 23 52 926 erläutert. WO2009075791 offenbart ein Verfahren und eine Vorrichtung nach den Oberbegriffen der Ansprüche 1 und 7.

Gemäß einem typischen Weiterverarbeitungsverfahren werden die durch Blasformen hergestellten Behälter einer nachfolgenden Fülleinrichtung zugeführt und hier mit dem vorgesehenen Produkt oder Füllgut gefüllt. Es werden also eine separate Blasmaschine und eine separate Füllmaschine verwendet. Bekannt ist es dabei auch, die separate Blasmaschine und die separate Füllmaschine zu einem Maschinenblock, d.h. zu einer verblockten Blas-Füll-Einrichtung zusammen zu fassen, wobei weiterhin das Blasformen und das Füllen an gesonderten Maschinenkomponenten und zeitlich nacheinander erfolgen.

Es wurde weiterhin bereits vorgeschlagen, Behälter, insbesondere auch in Form von Flaschen, aus thermisch konditionierten bzw. vorerhitzten Vorformlingen herzustellen und dabei gleichzeitig mit einem flüssigen Füllgut zu füllen, welches als hydraulisches Druckmedium zum Ausformen des Behälters durch Expandieren oder durch radiales und axiales Strecken oder Recken des Vorformlings mit einem Form-und Fülldruck zugeführt wird, sodass zeitgleich mit dem Füllen der jeweilige Vorformling in den Behälter verformt wird.

Bei allen vorstehend beschriebenen Verfahren ist auf die Sterilität bei der Abfüllung zu achten, um eine lange Haltbarkeit des Füllguts zu gewährleisten. Weiter sind viele flüssige Füllgüter sauerstoffempflindlich, und bei karbonisierten Flüssigkeiten wirken Fremdgase als Keimzelle für Ausgasung bei Druckabfall.

Aufgabe der Erfindung ist es, ein Verfahren sowie eine Vorrichtung zur Herstellung von mit einem flüssigen Füllgut gefüllten Behältern vorzuschlagen, die eine lange Haltbarkeit des Füllguts gewährleisten.

Zur Lösung dieser Aufgabe wird ein Verfahren und eine Vorrichtung nach Ansprüchen 1 und 7 vorgeschlagen.

Nach dem erfindungsgemäßen Verfahren wird der Vorformling vor Beginn der Form- und Füllphase mindestens einmal evakuiert. Vorzugsweise wird in den Vorformling nach der mindestens einen Evakuierung zur Entlastung ein inertes Gas oder Gasgemisch geleitet, idealerweise ein Inertgas, enthaltend oder bestehend aus CO₂ oder N₂. Der Vorformling kann auch alternativ oder kumulativ nach einer Evakuierung mit einem Inertgas gespült werden.

Vorzugsweise wird bei der Vakuumierung gemäß der Erfindung ein Druck von 50 bis 200 mbar erreicht. Dadurch werden alle Fremdgase aus dem Innenraum des Vorformlings entfernt, die einen schädlichen Einfluss auf das Füllmedium haben oder als Keimzelle für die Ausgasung einer kohlensäurehaltigen Flüssigkeit bei Druckabfall wirken könnten, wie z.B. Sauerstoff. Der im Vergleich zum ausgeformten Behälter relativ dickwandige Vorformling ist ausreichend stabil, um auch größerem Unterdruck standzuhalten. Das zu evakuierende Volumen ist vergleichsweise gering, weshalb das erfindungsgemäße Verfahren ökonomisch vorteilhaft ist.

Der Vorformling kann nach einer Evakuierung auch mit einem Sterilisationsmittel entlastet und/oder gespült werden, insbesondere mit Dampf und/oder einem Gas-Dampfgemisch. Der Dampf kann in diesem Fall ein Wasserdampf oder ein verdampftes chemisches Sterilisationsmittel sein, insbesondere H₂O₂. Als Sterilisationsmittel kann auch ein sterilisierendes Gas oder Gasgemisch zum Einsatz kommen, insbesondere Ozon oder ein Gemisch aus Ozon und einem inerten Gas.

Vorzugsweise kann die Mündung des Vorformlings durch einen Strahlungsemitter, insbesondere UV-Licht oder gepulstes UV-Licht, sterilisiert werden.

Der Form- und Füllvorgang kann unmittelbar nach der Evakuierung oder nach Entlastung, Spülung und Sterilisation beginnen. Die Evakuierung und die Spülung können auch mehrfach wiederholt werden, um eine möglichst hohe Freiheit von Fremdgasen im Vorformling zu erreichen, die Verunreinigungen der Atmosphäre im Vorformling darstellen.

Der Form- und Füllvorgang geschieht dann in bekannter Weise, wobei der Vorformling erforderlichenfalls vor Beginn des Formvorgangs thermisch konditioniert wird. Hierfür übliche Temperaturen liegen zwischen 70°C und 120°C. Die thermische Konditionierung kann z. B. auch in üblicher Weise durch Durchlaufen einer Heizstrecke vor Einbringen des Vorformlings in die Form erfolgen. Vorzugsweise ist die Form dann entsprechend geheizt, um die thermische Konditionierung während der Vorbehandlung des Vorformlings durch Vakuumierung, Spülung und/oder Sterilisierung aufrecht zu erhalten.

Ein verfahrensgemäß vorbereiteter Vorformling kann im Rahmen der Form-und Füllphase in einem Arbeitsgang mit einem flüssigen Füllmedium geformt und gefüllt werden. Eine erneute Verunreinigung kann durch das unmittelbare Aufeinanderfolgen der Verfahrenschritte ausgeschlossen werden.

Der Formkopf der erfindungsgemäßen Vorrichtung verfügt über geeignete Mittel zum Evakuieren des Innenraums des Vorformlings zur Herstellung eines Vakuums, oder ist mit solchen, wie z.B. mit einer Vakuumpumpe, funktional verbunden, z.B. über Leitungen. Der im Innenraum des Vorformlings erreichbare Druck sollte dabei vorzugsweise zwischen 50 und 200 mbar liegen.

In einer vorteilhaften Ausführung der Vorrichtung stehen mindestens eine Gruppe von Formköpfen gemeinsam mit einem gemeinsamen Unterdruckraum in Verbindung, der seinerseits mit Mitteln zum Evakuieren, wie z.B. einer Vakuumpumpe, in Verbindung steht. Insbesondere können alle Formköpfe mit einem einzigen Unterdruckraum leitungsmäßig verbunden sein. Der Unterdruckraum kann vorteilhaft als ein oder mehrere Ringkessel oder Ringrohre ausgebildet sein.

Die Vorrichtung kann über Mittel zum thermischen Konditionieren des Vorformlings verfügen.

Die Formkopf der erfindungsgemäßen Vorrichtung kann vorzugsweise weiter über Mittel zur Einleitung eines Sterilisationsmittels, wie z.B. von Dampf, eines Gas-Dampfgemisches, von Ozon und/oder von H₂O₂ in den Innenraum des Vorformlings verfügen. Damit kann der Vorformling wirksam desinfiziert werden. Das nachfolgend abgefüllte Füllmedium verfügt so über eine lange Haltbarkeit.

Der Formkopf kann auch über Mittel zur Einleitung eines Inertgases, insbesondere enthaltend oder bestehtend aus CO₂ oder N₂, in den Innenraum des Vorformlings verfügen. Damit kann der Vorformling wirksam inertisiert werden, was ebenfalls zur langen Haltbarkeit des abgefüllten Mediums beiträgt.

In einer bevorzugten Ausführungsform kann der Formkopf der erfindungsgemäßen Vorrichtung über Mittel zur Sterilisation der Mündung des Vorformlings durch einen Strahlungsemitter verfügen, insbesondere einen UV-Strahler oder Strahler für gepulstes UV-Licht. Der Vorformling kann so vor Beginn der Form- und Füllphase vollständig sterilisiert werden. Der fertige, gefüllte Behälter muss nicht erneut einem Sterilisationsprozess unterworfen werden.

Die Erfindung wird im Folgenden anhand der beigefügten Figur an einem Ausführungsbeispiel näher erläutert:

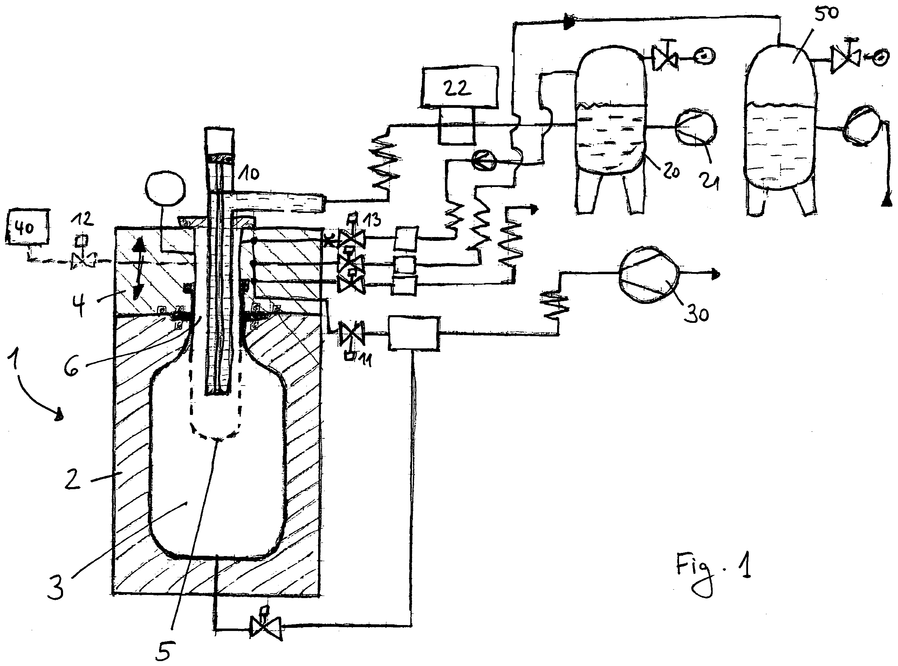

**Fig. 1** zeigt in schematischer Darstellung eine erfindungsgemäße Anlage zur Herstellung von mit einem flüssigen Füllgut gefüllten Behältern aus Vorformlingen **5.**

Die in Fig. 1 dargestellte Anlage verfügt über wenigstens eine Form- und Füllstation **1,** die jeweils zumindest eine einen Formraum **3** bildende Form **2** aufweist. Die Form **2** wird durch einen Formkopf **4** nach oben abgeschlossen.

Ein in der Figur gestrichelt dargestellter Vorformling **5** kann in die Form eingebracht werden und liegt mit seiner Öffnung **6** in Dichtlage gegen den Formkopf **4** an.

Der Formkopf **4** ist über eine Zuleitung mit einem ersten Speicher **20** für ein flüssiges Füllgut verbunden, in dem das Füllgut durch eine Hochdruckpumpe **21** unter hohem Druck steht und dem Vorformling **5** über ein Ventil **10** zugeführt werden kann. Das zugeführte Volumen kann dabei über einen magnetisch induktiven Durchflussmesser (MID) **22** gemessen werden.

Weiter ist der Formkopf **4** über eine Zuleitung mit einer Vakuumpumpe **30** verbunden, mit der im Vorformling **5** über ein Ventil **11** ein Vakuum von etwa 100 mbar generiert werden kann.

Der Formkopf **4** ist außerdem über eine Zuleitung mit einer Quelle zur Erzeugung von Dampf und/oder einem H₂O₂-Speicher **40** verbunden, so dass der Vorformling **5** über ein Ventil **12** mit Dampf, insbesondere mit Wasserdampf, und/oder verdampftem H₂O₂ beaufschlagt werden kann.

Der Formkopf **4** ist zudem über eine Zuleitung mit einem CO₂-Speicher **50** verbunden, so dass der Vorformling **5** über ein Ventil **13** mit CO₂ beaufschlagt werden kann.

Die Herstellung eines mit einem flüssigen Füllgut gefüllten Behälters gemäß dem erfindungsgemäßen Verfahren erfolgt in der nachstehend beschriebenen Weise: Zunächst wird der Vorformling **5** in die geöffnete Form **2** eingebracht und der Formkopf **4** geschlossen, so dass die Öffnung **6** des Vorformlings **5** dichtend mit dem Formkopf **4** in Anlage gerät.

Im ersten Schritt wird Ventil **11** geöffnet, so dass das von der Vakuumpumpe **30** erzeugte Vakuum auf den Vorformling **5** einwirken kann. Der Vorformling **5** wird evakuiert. Der Vorformling **5** ist im Gegensatz zum ausgeformten Behälter sehr stabil, so dass er erheblichen Unterdruck aushält. Die Evakuierung stellt deshalb kein Problem dar. Angesichts des kleinen Volumens des Vorformlings **5** lässt sich die Evakuierung innerhalb eines sehr kleinen Zeitintervalls durchführen, was für die Prozesszeiten innerhalb einer Abfüllmaschine wichtig ist.

Im nächsten Schritt wird Ventil **11** geschlossen und Ventil **12** geöffnet. Dadurch kommuniziert der unter Unterdruck stehende Vorformling **5** mit dem Dampferzeuger und/oder H₂O₂-Speicher **40** und wird entlastet. Durch den Unterdruck werden Wasserdampf und/oder verdampftes H₂O₂ in den Innenraum des Vorformlings **5** gesaugt und die mit dem Füllgut in Berührung kommenden Flächen des Vorformlings **5** werden sterilisiert.

Nach Abschluss dieser Phase wird Ventil **12** geschlossen und erneut Ventil **11** geöffnet, so dass erneut ein Vakuum im Innenraum des Vorformlings **5** erzeugt wird.

Nach Schließen des Vakuumventils **11** kann Ventil **13** geöffnet werden, wodurch der Innenraum des Vorformlings **5** erneut entlastet und mit CO₂ gespült wird. In Bezug auf die meisten Getränke ist CO₂ ein Inertgas und verursacht keine Verschlechterung des Getränks.

Nach Abschluss dieser Phase wird Ventil **13** wieder geschlossen und durch Öffnen des Ventils **10** wird der Form- und Füllprozess in Gang gesetzt. Unter dem im Behälter **20** herrschenden Form- und Fülldruck wird das im Vorformling **5** befindliche Inertgas verdrängt und der Vorformling in den Behälter umgeformt. Es versteht sich von selbst, dass der Vorformling in üblicher und bekannter Weise vor der Form- und Füllphase thermisch konditioniert wird.

Ganz allgemein kann die Streckung des Vorformlings **5** durch geeignete Mittel, die in der Figur nicht dargestellt sind, unterstützt und gesteuert werden. Es kann beispielsweise eine Reckstange, ein von unten am Boden des Vorformlings angreifendes Führungselement oder Unterdruck in der Form eingesetzt werden. Eine Kombination dieser Mittel ist ebenfalls möglich. Besonders vorteilhaft sind Verfahren, bei denen keine herkömmliche Reckstange im Inneren der Vorformlinge bzw. der Behälter zum Einsatz kommt, sondern der Vorformling bei der Umformung von außen, vorzugsweise am Boden angreifend, geführt wird.

Nach Ausformung und Füllung des Behälters wird in geeigneter Weise ein Kopfraum gebildet, der Behälter entlastet und verschlossen.

Es versteht sich von selbst, dass die hier schematisch dargestellte Anlage über mehrere Form- und Füllstationen **1** verfügen kann, an denen simultan oder zeitlich geringfügig versetzt mehrere Behälter gleichzeitig geformt werden können. Ebenso versteht sich von selbst, dass das dargestellte Verfahren mehr als jeweils einen Zyklus aus Evakuierung und Desinfektion bzw. Evakuierung und Spülung mit Inertgas umfassen kann.

### Bezugszeichenliste

- 1: Form- und Füllstation
- 2: Form
- 3: Formraum
- 4: Formkopf
- 5: Vorformling
- 6: Öffnung des Vorformlings

- 10: Ventil für Füllgutzufuhr
- 11: Ventil für Vakuumpumpe
- 12: Ventil für Dampferzeuger / H₂O₂-Speicher
- 13: Ventil Inertgasspeicher

- 20: Speicher für Füllgut
- 21: Hochdruckpumpe
- 22: Magnetisch induktiver Durchflussmesser (MID)

- 30: Vakuumpumpe

- 40: H₂O₂-Speicher, Dampferzeuger

- 50: CO₂-Speicher

## Patentansprüche

1. Verfahren zur Herstellung von mit einem flüssigen Füllgut (20) gefüllten Behältern aus Vorformlingen (5), insbesondere Kunststoffbehälter, wie PE-, PP-, PET-Flaschen, PET-KEG und dergleichen, wobei der Vorformling (5) während einer Form- und Füllphase in einer Form (2) hydraulisch oder hydro-dynamisch durch Druckeinwirkung des zugeführten Füllguts in den Behälter umgeformt wird, **dadurch gekennzeichnet, dass** der Vorformling (5) vor Beginn der Form- und Füllphase mindestens einmal auf einen Druck von 50 bis 200 mbar evakuiert wird und dass der Vorformling (5) nach einer ersten Evakuierung mit einem Sterilisationsmittel (40), insbesondere mit Dampf und/oder Gas-Dampfgemisch, entlastet und/oder gespült wird.

2. Verfahren nach Anspruch 1, **dadurch gekennzeichnet, dass** der Dampf ein Wasserdampf oder ein verdampftes chemisches Sterilisationsmittel ist, insbesondere H₂O₂.

3. Verfahren nach Anspruch 1, **dadurch gekennzeichnet, dass** das Sterilisationsmittel ein sterilisierendes Gas oder Gasgemisch ist, insbesondere Ozon oder Ozon mit einem inerten Gas.

4. Verfahren nach Anspruch 1 bis 3, **dadurch gekennzeichnet, dass** nach mindestens einer erneuten Evakuierung des Vorformlings zur Entlastung ein inertes Gas oder Gasgemisch in den Vorformling geleitet wird, idealerweise ein Inertgas (50), enthaltend oder bestehend aus CO₂ oder N₂.

5. Verfahren nach Anspruch 4, **dadurch gekennzeichnet, dass** der Vorformling nach einer erneuten Evakuierung mit dem Inertgas (50) gespült wird.

6. Verfahren nach einem der Ansprüche 1 bis 5, **dadurch gekennzeichnet, dass** die Mündung des Vorformlings (5) durch einen Strahlungsemitter, insbesondere UV-Licht oder gepulstes UV-Licht, sterilisiert wird.

7. Vorrichtung zur Herstellung von mit einem flüssigen Füllgut gefüllten Behältern aus Vorformlingen (5) mit wenigstens einer Form- und Füllstation (1), die zumindest eine einen Formraum (3) bildende Form (2) sowie zumindest einen Formkopf (4) aufweist, über den zum Umformen des jeweiligen Vorformlings (5) in einen Behälter in den Innenraum des mit seiner Öffnung (6) in Dichtlage gegen den Formkopf (4) anliegenden Vorformling (5) ein flüssiges Druckmedium (20) eingebracht werden kann, **dadurch gekennzeichnet, dass** der Formkopf (4) über Mittel zum Evakuieren (11, 30) des Innenraums des Vorformlings (5) auf einen Druck von 50 bis 200 mbar verfügt oder mit solchen funktional verbunden ist, insbesondere über Leitungen, dass der Formkopf (4) über Mittel (12, 40) zur Einleitung eines Sterilisationsmittels, insbesondere von Dampf, eines Gas-Dampfgemisches, von Ozon und/oder von H₂O₂, in den Innenraum des Vorformlings (5) verfügt, und wobei mindestens eine Gruppe von Formköpfen (4) gemeinsam mit einem gemeinsamen Unterdruckraum in Verbindung stehen, welcher seinerseits mit einem Mittel zum Evakuieren (11,30) in Verbindung steht, insbesondere, dass alle Formköpfe (4) mit einem einzigen Unterdruckraum leitungsmäßig verbunden sind.

8. Vorrichtung nach Anspruch 7, **dadurch gekennzeichnet, dass** der Unterdruckraum als ein oder mehrere Ringkessel oder Ringrohre ausgebildet ist.

9. Vorrichtung nach einem der Ansprüche 7 oder 8, **dadurch gekennzeichnet, dass** die Vorrichtung über Mittel zum thermischen Konditionieren des Vorformlings (5) verfügt.

10. Vorrichtung nach einem der Ansprüche 7 bis 9, **dadurch gekennzeichnet, dass** der Formkopf (4) über Mittel (13, 50) zur Einleitung eines Inertgases, insbesondere enthaltend oder bestehend aus CO₂ oder N₂, in den Innenraum des Vorformlings (5) verfügt.

11. Vorrichtung nach einem der Ansprüche 7 bis 10, **dadurch gekennzeichnet, dass** der Formkopf (4) über Mittel zur Sterilisation der Mündung des Vorformlings (5) durch einen Strahlungsemitter verfügt, insbesondere UV-Strahler oder Strahler für gepulstes UV-Licht.

## Claims

1. Method for producing containers from preforms (5), said containers being filled with liquid contents (20), in particular for producing plastic containers such as PE, PP, or PET bottles, PET kegs, and similar, wherein the preform (5) is formed hydraulically or hydrodynamically during a form-and-fill phase in a mould (2) by the pressure effect of the filling product introduced into the container, **characterised in that** the preform (5) is evacuated at least once prior to the beginning of the form-and-fill phase to a pressure of 50 to 200 mbar, and that, after a first evacuation, the preform (5) is pressure-balanced and/or rinsed using a sterilisation agent (40), in particular with steam and/or a mixture of gas and steam.

2. Method according to claim 1, **characterised in that** the steam is a water vapour or an evaporated chemical sterilisation agent, in particular H₂O₂.

3. Method according to claim 1, **characterised in that** the sterilisation agent is a sterilising gas or gas mixture, in particular ozone or ozone with an inert gas.

4. Method according to claims 1 to 3, **characterised in that,** after at least one renewed evacuation of the preform, for pressure-balancing an inert gas or gas mixture is introduced into the preform, ideally an inert gas (50) containing or consisting of CO₂ or N₂.

5. Method according to claim 4, **characterised in that,** after a renewed evacuation, the preform is rinsed with an inert gas (50).

6. Method according to any one of claims 1 to 5, **characterised in that** the mouth of the preform (5) is sterilised by a radiation emitter, in particular of UV light or pulsed UV light.

7. Device for producing containers filled with a liquid contents from preforms (5) with at least one forming and filling station (1), which comprises at least one mould (2), forming a mould space (3), as well as at least one moulding head (4), by means of which, for forming the respective preform (5) into a container, a liquid pressure medium (20) can be introduced into the interior of the preform (5), which is in contact in sealing position with its opening (6) against the moulding head (4), **characterised in that** the moulding head (4) is provided with means for evacuating (11, 30) the interior of the preform (5) to a pressure of 50 to 200 mbar, or is functionally connected to such means, in particular by means of lines, that the moulding head (4) is provided with means (12, 40) for the introduction of a sterilisation medium, in particular of steam, a gas-steam mixture, of ozone, and/or of H₂O₂, into the interior of the preform (5), and wherein at least one group of moulding heads (4) are in connection in common with a common underpressure chamber, which in turn is in connection with a means for evacuation (11, 30), and, in particular, that all the moulding heads (4) are connected by lines to one single underpressure chamber.

8. Device according to claim 7, **characterised in that** the underpressure chamber is configured as one or a plurality of ring chambers or ring tubes.

9. Device according to any one of claims 7 or 8, **characterised in that** the device is provided with means for the thermal conditioning of the preform (5).

10. Device according to any one of claims 7 to 9, **characterised in that** the moulding head (4) is provided with means (13, 50) for the introduction of an inert gas, in particular containing or consisting of CO₂ or N₂, into the interior of the preform (5).

11. Device according to any one of claims 7 to 10, **characterised in that** the moulding head (4) is provided with means for sterilising the mouth of the preform (5) by a radiation emitter, in particular a UV emitter or an emitter of UV light.

## Revendications

1. Procédé de fabrication de contenants remplis d'un produit de remplissage fluide (20) à partir de préformes (5), en particulier de contenants en plastique, comme des bouteilles en PE, PP, PET, des fûts en PET et similaires, dans lequel la préforme (5) est transformée pendant une phase de moulage et de remplissage dans un moule (2) de manière hydraulique ou hydrodynamique sous l'effet de la pression du produit de remplissage amené dans le récipient, **caractérisé en ce que** la préforme (5) avant le début de la phase de moulage et de remplissage est évacuée au moins une fois à une pression de 50 à 200 mbar et **en ce que** la préforme (5) est déchargée et/ou rincée après une première évacuation avec un moyen de stérilisation (40), en particulier avec de la vapeur et/ou un mélange gaz-vapeur.

2. Procédé selon la revendication 1, **caractérisé en ce que** la vapeur est une vapeur d'eau ou un moyen de stérilisation chimique vaporisé, en particulier H₂O₂.

3. Procédé selon la revendication 1, **caractérisé en ce que** le moyen de stérilisation est un gaz ou mélange de gaz stérilisant, en particulier de l'ozone ou de l'ozone avec un gaz inerte.

4. Procédé selon la revendication 1 à 3, **caractérisé en ce qu'**après au moins une nouvelle évacuation de la préforme pour la décharge, un gaz ou mélange de gaz inerte est guidé dans la préforme, idéalement un gaz inerte (50), contenant ou composé de CO₂ ou de N₂.

5. Procédé selon la revendication 4, **caractérisé en ce que** la préforme est rincée après une nouvelle évacuation avec le gaz inerte (50).

6. Procédé selon l'une quelconque des revendications 1 à 5, **caractérisé en ce que** l'embouchure de la préforme (5) est stérilisée par un émetteur de rayonnement, en particulier de la lumière UV ou de la lumière UV pulsée.

7. Dispositif de fabrication de contenants remplis d'un produit de remplissage fluide à partir de préformes (5) avec au moins une station de moulage et de remplissage (1), qui présente au moins un moule (2) formant un espace de moulage (3) ainsi qu'au moins une tête de moulage (4), via laquelle un moyen de pression fluide (20) peut être introduit pour la transformation de la préforme concernée (5) en un contenant dans l'espace intérieur de la préforme (5) s'appliquant avec son ouverture (6) en position étanche contre la tête de moulage (4), **caractérisé en ce que** la tête de moulage (4) dispose de moyens d'évacuation (11, 30) de l'espace intérieur de la préforme (5) à une pression de 50 à 200 mbar et est reliée à ceux-ci de manière fonctionnelle, en particulier par le biais de conduites, **en ce que** la tête de moulage (4) dispose de moyens (12, 40) d'introduction d'un moyen de stérilisation, en particulier de vapeur, d'un mélange gaz-vapeur, d'ozone et/ou de H₂O₂, dans l'espace intérieur de la préforme (5), et dans lequel au moins un groupe de têtes de moulage (4) communiquent conjointement avec un espace de dépression commun, qui communique de son côté avec un moyen d'évacuation (11, 30), en particulier **en ce que** toutes les têtes de moulage (4) sont reliées par conduite avec un espace de dépression unique.

8. Dispositif selon la revendication 7, **caractérisé en ce que** l'espace de dépression est réalisé sous la forme d'une ou plusieurs cuves annulaires ou tubes annulaires.

9. Dispositif selon l'une quelconque des revendications 7 ou 8, **caractérisé en ce que** le dispositif dispose de moyens de conditionnement thermique de la préforme (5).

10. Dispositif selon l'une quelconque des revendications 7 à 9, **caractérisé en ce que** la tête de moulage (4) dispose de moyens (13, 50) d'introduction d'un gaz inerte, en particulier contenant ou composé de CO2 ou de N2, dans l'espace intérieur de la préforme (5).

11. Dispositif selon l'une quelconque des revendications 7 à 10, **caractérisé en ce que** la tête de moulage (4) dispose de moyens de stérilisation de l'embouchure de la préforme (5) par un émetteur de rayonnement, en particulier un émetteur d'UV ou un émetteur de lumière UV pulsée.
